(19) Europäisches Patentamt

European Patent Office

Office européen des brevets

(11) **EP 0 957 349 B1**

(12) **EUROPÄISCHE PATENTSCHRIFT**

(45) Veröffentlichungstag und Bekanntmachung des Hinweises auf die Patenterteilung:
**21.12.2005 Patentblatt 2005/51**

(51) Int Cl.⁷: **G01K 7/01**, G01D 5/246, H03K 9/08

(21) Anmeldenummer: **99107789.2**

(22) Anmeldetag: **20.04.1999**

(54) **Messwertaufnehmer zur Temperaturmessung an ölgefüllten Betriebsmitteln und dafür geeignetes Verfahren zur Temperaturmessung**

Device for measuring temperature in oil-filled installations and method adapted therefor

Transducteur pour mesurer la température dans des installations remplies d'huile et méthode associée

(84) Benannte Vertragsstaaten:
**AT BE CH DE DK ES FI FR GB IT LI NL SE**
Benannte Erstreckungsstaaten:
**RO**

(30) Priorität: **14.05.1998 DE 19821773**

(43) Veröffentlichungstag der Anmeldung:
**17.11.1999 Patentblatt 1999/46**

(73) Patentinhaber: **Maschinenfabrik Reinhausen GmbH**
**93059 Regensburg (DE)**

(72) Erfinder:
• **Stadelmayer, Manfred**
**93173 Wenzenbach (DE)**

• **Viereck, Karsten Dr.-Ing.**
**93128 Diesenbach (DE)**

(56) Entgegenhaltungen:
**EP-A- 0 450 418**          **US-A- 3 798 432**

• **"TEMPERATURSENSOR MIT INTEGRIERTEM ANALOG-DIGITAL-WANDLER" UND- ODER-NOR + STEUERUNGSTECHNIK, Bd. 25, Nr. 6, 1. Juni 1992 (1992-06-01), Seite 54, 57 XP000304910**
• **SPENCER R R ET AL: "A VOLTAGE-CONTROLLED DUTY-CYCLE OSCILLATOR" IEEE JOURNAL OF SOLID-STATE CIRCUITS, Bd. 25, Nr. 1, 1. Februar 1990 (1990-02-01), Seiten 274-281, XP000101877 ISSN: 0018-9200**

**Beschreibung**

Die Erfindung betrifft einen Meßwertaufnehmer zur Temperaturmessung an ölgefüllten Betriebsmitteln, insbesondere zur Messung der Öltemperatur von Transformatoren und Stufenschaltern.

Die Erfindung betrifft weiterhin ein geeignetes Verfahren unter Verwendung eines solchen Meßwertaufnehmers.

Für die Messung der Betriebstemperatur der o. a. Geräte, d. h. insbesondere deren Öltemperatur, werden bisher üblicherweise Widerstandsthermometer verwendet. Solche Widerstandsthermometer sind seit langem Stand der Technik; sie werden von zahlreichen Herstellern angeboten, ihr Aufbau und ihre Abmessungen sind genormt. Für Deutschland gilt beispielsweise die DIN 42554, für andere Länder sind andere Normen zu beachten. Für die USA und Kanada etwa sind genormte Verschraubungen der Typen 3/8" NPT oder 7/8 - 14 UNF üblich.

Hersteller bekannter Widerstandsthermometer sind z. B. die Firmen Messko Hauser, Thermometerwerk Geraberg und Sika GmbH, alle DE, sowie Qualitrol Corp., N. Y., USA. Qualitrol bietet z. B. für die genannten Anwendungszwecke Thermometer der Serien 165/167, 104, 104-400 an. Diese Baureihen sind in den Firmenbroschüren QT-150, QT-165, QT-104-2, QT 104-321, QT 104-400 der Herstellerin beschrieben.

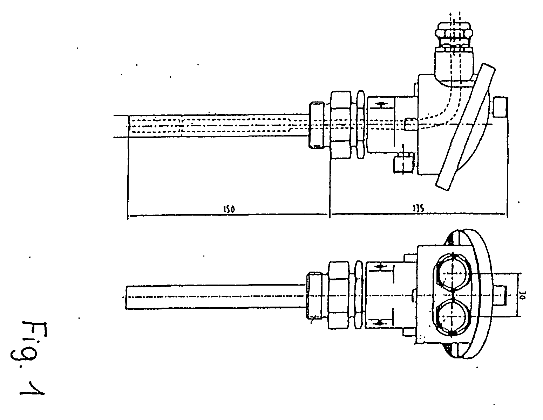

Ein bekanntes Widerstandsthermometer ist in Fig. 1 dargestellt.

Es wird mittels einer Verschraubung in eine Thermometertasche am jeweiligen Betriebsmittel, dessen Temperatur gemessen werden soll, versenkt und eingeschraubt und weist im unteren Bereich, der eingeschraubt wird, ein perforiertes Schutzrohr mit dem eingebauten, auswechselbaren Meßeinsatz auf.

Im oberen, aus dem jeweiligen Betriebsmittel herausragenden Bereich besitzt das bekannte Widerstandsthermometer Kabelverschraubungen für die herauszuführenden elektrischen Meßleitungen sowie in aller Regel eine Entlüftungsvorrichtung.

Ein solches bekanntes Widerstandsthermometer als Meßwertaufnehmer sowie das entsprechende Verfahren zur eigentlichen Temperaturmessung unter Verwendung dieses

Widerstandsthermometers weisen eine Reihe von Nachteilen auf. Zunächst einmal benötigen bekannte Widerstandsthermometer zur Öltemperaturmessung zu ihrer exakten Funktion einen Potentialausgleich zwischen Meß- und Versorgungsanschluß in Form eines Drei- oder Vier-Leiteranschlusses. Dies ist beispielsweise in den Firmendruckschriften QT-109-020, QT-109-100, QT-DTM der Firma Qualitrol dargestellt.

Weiterhin können Übergangswiderstände oder eine unerwünschte Elementbildung, d. h. Bildung von Fremdschichten, an den Klemmstellen der Meß- und Versorgungsleitungen das Meßergebnis verfälschen.

Außerdem sind die Widerstandsthermometer, besonders der eigentliche Meßwiderstand, anfällig gegen etwaige EMV-Einflüsse und machen daher zusätzliche Kompensationsmittel erforderlich. Unter dem Begriff "EMV-Einflüsse" (EMV steht dabei als Abkürzung für ElektroMagnetische Verträglichkeit) werden dabei störende Einflüsse von außen wirkender elektromagnetrischer bzw. elektrostatischer Felder verstanden (sog. "electromagnetic enviroment", "electromagnetic interferences"). Ein weiterer Nachteil besteht darin, daß das Meßsignal, das in Abhängigkeit vom temperaturabhängigen Wert des Meßwiderstandes erzeugt wird, durch einen Meßwertumsetzer zusätzlich aufbereitet werden muß, um für ein Anzeigegerät oder etwa einen Computer geeignet zu sein. Dies ist dadurch begründet, daß das Ausgangssignal bekannter Widerstandsthermometer nicht kompatibel für nachgeordnete Meßgeräte o. ä. ist. Bei bekannten Widerstandsthermometern ist die Widerstandsänderung $\Delta$ R abhängig von der Temperatur $\vartheta$, also: $\Delta$ R = f ($\vartheta$). Elektronische Geräte jedoch erfordern genormte, genau definierte Signalpegel, etwa im Bereich 0...10 V und 0...20 mA, in den USA auch 0...1 mA. Dies macht eine Signalaufbereitung bzw. - aufarbeitung zwingend notwendig.

Schließlich ist auch eine Überprüfung der Funktionsfähigkeit des Widerstandsthermometers und damit der Sicherheit und Genauigkeit der Temperaturmessung im laufenden Betrieb nicht möglich; Widerstandsthermometer können nur durch eine geeignete separate Referenzmessung offline überprüft werden.

Aus der US 3,798,432 ist ein Gerät zur Auswertung von pulsbreitenmodulierten Signalverläufen, die am Ausgang einer symmetrischen Schalteinrichtung erhalten werden, beschrieben. Dabei wird die algebraische Summe der an den Ausgängen der Schalteinrichtung anstehenden Signale gebildet, wobei einer der Signalverläufe in ein modifiziertes, symmetrisches Signal umgewandelt wird.

Aus der EP 450 418 A2 ist weiterhin eine Einrichtung zum Übertragen eines pulsbreitenmodulierten elektrischen Eingangssignals bekannt, wobei das Eingangssignal über einen Transformator geführt wird, der zwei gegensinnige Ausgangsspannungen liefert. Durch die beschriebene antiparallele Signalführung können Fehler vermieden werden, die aus dem spezifischen Ansprechverhalten der in der Einrichtung befindlichen Schwellwertstufen resultieren.

Die Erfindung stellt sich die Aufgabe, die Nachteile der bekannten Systeme zu beseitigen und einen Meßwertaufnehmer sowie ein unter Verwendung eines solchen Meßwertaufnehmers arbeitendes Meßwertverfahren anzugeben, die auf einfache Weise eine genaue und zuverlässige Temperaturerfassung, Fernübertragung des Meßsignales und Weiterverarbeitung der solcherart übermittelten Informationen gestatten.

Diese Aufgabe wird erfindungsgemäß gelöst durch einen Meßwertaufnehmer mit den Merkmalen des ersten Patentanspruches.

Diese Aufgabe wird weiterhin gelöst durch ein Verfahren mit den Merkmalen des nebengeordneten zweiten Patentanspruches.

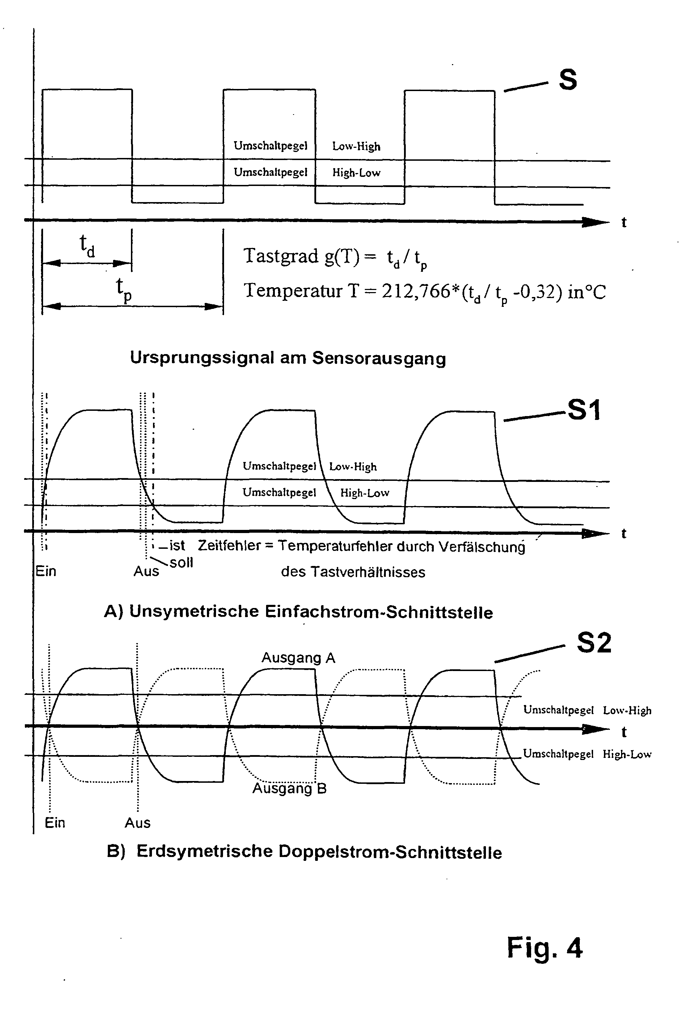

Der erfindungsgemäße Meßwertaufnehmer zur Temperaturmeßung arbeitet mit einem Temperatursensor, der - abhängig von der jeweiligen Temperatur - ein tastgradmoduliertes Ausgangssignal erzeugt; mit anderen Worten: Er erzeugt Impulse, deren jeweiliges Tastverhältnis ein Maß für die aktuell gemessene Temperatur ist. Unter "tastgradmoduliert" wird also das zeitliche Verhältnis zwischen den "High-" und "Low-"Flanken innerhalb eines Impulses verstanden, ausgedrückt durch die Formel für den Tastgrad, so wie dies in Figur 4 dargestellt ist. Wie erläutert, ist der jeweilige Tastgrad ein Maß für die entsprechende Temperatur; deren Ermittlung daraus ist nach der ebenfalls in Figur 4 dargestellten weiteren Formel möglich.

Tastgradmodulierte Temperatursensoren per se sind bereits bekannt; sie werden z. B. von der Fa. Ginsbury, GB angeboten, für die Temperaturmessung an ölgefüllten Betriebsmitteln wie Transformatoren oder Stufenschaltern, in die sie eingesenkt werden, wurden sie bisher jedoch nicht verwendet.

Nach einem weiteren Merkmal der Erfindung sind zusätzliche Bauteile vorhanden, die dem Schutz vor elektromagnetischen Störungen dienen und deren Funktion später noch näher erläutert werden wird.

Weiterhin ist erfindungsgemäß ein Interfaceschaltkreis vorgesehen, der einen Polaritätswechsel eines elektrischen Signales ermöglicht und ebenfalls später noch näher erläutert wird.

Nach einem weiteren Merkmal der Erfindung sind alle genannten Bauteile des Meßwertaufnehmers in einem bekannten, genormten Gehäuse eines Widerstandsthermometers angeordnet. Dadurch bleibt die volle Kompatibilität gewährleistet; es ist ohne weiteres der Einbau des erfindungsgemäßen Meßwertaufnehmers anstelle eines Widerstandsthermometers in einer Thermometertasche am Transformator möglich. Ebenso ist die nachträgliche Umrüstung ohne weiters ausführbar.

Der erfindungsgemäße Meßwertaufnehmer weist gegenüber dem Stand der Technik eine ganze Reihe von Vorteilen auf Zunächst einmal ermöglicht er auf einfache Weise die Selbstüberwachung, da das Fehlen des temperaturproportionalen, tastgradmodulierten Ausgangssignales bei intakter Stromversorgung eindeutig einen Defekt signalisiert. Weiterhin sind kein Meßwertumsetzer sowie kein A/D-Wandler mehr erforderlich, und die überbrückbare Leitungslänge bis zu einer Fernanzeige oder einer Weiterverarbeitung des gewonnenen, digitalen Meßsignales ist wesentlich größer als bisher üblich. Das in digitaler Form anstehende und übertragene Meßsignal kann unmittelbar von einem Mikroprozessor verarbeitet werden.

Das erfindungsgemäße Verfahren gemäß Patentanspruch 2 geht von der Tatsache aus, daß der dem Verfahren zugrundeliegende erfindungsgemäße Meßwertaufnehmer ein temperaturabhängiges, tastgradmoduliertes Ausgangssignal liefert. Mit anderen Worten: Impulse werden generiert, deren jeweiliges Tastverhältnis ein Maß für die aktuell gemessene Temperatur ist. Dies wurde weiter oben mit Bezug auf Figur 4 bereits erläutert. Diese Signale werden zum Schutz gegen störende EMV-Einflüsse durch an sich bekannte RC- bzw. LC-Beschaltungen geleitet; dadurch kommt es zu einer Flankenverschleifung des tastgradmodulierten Meßsignals. Ohne weitere Maßnahmen würde dies notwendigerweise zu einem Meßfehler führen. Der Begriff "EMV-Einflüsse" wurde ebenfalls weiter oben bereits erläutert. Unter "RC- bzw. LC-Beschaltungen" sind bekannte Kombinationen aus Widerständen und Kondensatoren (RC) bzw. Induktivitäten und Kondensatoren (LC) zu verstehen. "Flankenverschleifung" heißt dabei, daß der Impuls nicht mehr streng mäanderförmig verläuft, sondern abgerundete Flanken aufweist, die von der Rechteckform abweichen. Auch hierzu wird auf Figur 4 verwiesen; dort ist oben ein streng mäanderförmiges Signal dargestellt, in der Mitte ist es nach der beschriebenen Flankenverschleifung gezeigt. Ein weiterer Verfahrensschritt besteht in der Erzeugung eines Polaritätswechsels zu Beginn jeder Flanke des Meßsignales, d. h., es wird quasi ein künstlicher Nullpunkt in die Kurve des Meßsignals hineinverlegt. Nachfolgend kann auf einfache Weise eine Erfassung der Nulldurchgänge des solcherart umgewandelten Meßsignales und daraus wiederum die Ableitung der Information über die gemessene Temperatur erfolgen.

Der wesentliche Vorteil des erfindungsgemäßen Verfahrens besteht also darin, daß die durch die notwendigen Bauelemente gegen störende EMV-Einflüsse unvermeidlichen Flankenverschleifungen des tastgradmodulierten Meßsignales derart kompensiert werden, daß unabhängig von Art und Größe solcher Verschleifungen eine objektive Information über die jeweils gemessene Temperatur in digitaler Form abgeleitet und zur weiteren Verarbeitung übermittelt werden kann.

Ein weiterer Vorteil des Verfahrens besteht darin, daß etwaige Temperaturfehler vermieden werden. Darauf wird später noch eingegangen werden.

Schließlich ist, wie bereits ausgeführt, das Meßsignal in digitaler Form verfügbar und kann als solches auf einfache Weise digital übertragen und anschließend weiterverarbeitet werden.

Die Erfindung soll nachfolgend anhand von Zeichnungen beispielhaft noch näher erläutert werden.

Die Figuren zeigen:

Fig. 1     die äußere Kontur eines bekannten Widerstandsthermometers, das bereits erläutert wurde

Fig. 2     die Prinzipschaltung eines erfindungsgemäßen Meßwertaufnehmers

Fig. 3     eine schematische Darstellung des Ablaufes des erfindungsgemäßen Verfahrens

Fig. 4     eine ebenfalls schematische Darstellung des Ursprungssignals am Sensorausgang, eines fehlerbehafteten Signales nach dem Stand der Technik sowie eines fehlerfrei weiterverarbeitbaren Signales gemäß der Erfindung.

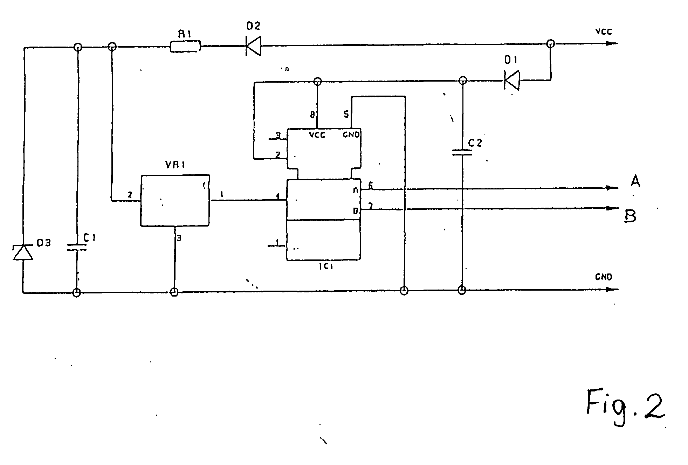

Fig. 2 zeigt in schematischer Darstellung die einzelnen Bestandteile des erfindungsgemäßen Meßwertaufnehmers, die sich alle im Inneren des bekannten Gehäuses eines Widerstandsthermometers befinden.

Wesentlicher Bestandteil des Meßwertaufnehmers ist ein Temperatursensor VR1, der zur eigentlichen Temperaturerfassung dient. Er ist verbunden mit einem Interfaceschaltkreis IC1. Der Interfaceschaltkreis IC 1 ermöglicht einen permanenten Polaritätswechsel des vom Temperatursensor VR1 übermittelten Meßsignales und stellt das solcherart veränderte Meßsignal an seinen Ausgängen A und B zur Verfügung.

Die weiteren Bauteile D1, D2, D3, C1 sowie C2 dienen dem EMV-Schutz der Anordnung und des Meßwertaufnehmers insgesamt. R1 dient dabei zur Begrenzung des Ladestromes von C1 und des Ableitstromes von D3. Aus R1 x C1 ergibt sich $t_z$, die elektrische Zeitkonstante der Spannungsglättung, d. h. die Dämpfung der wirkenden Versorgungsspannung. C2 ist der Ladekondensator der Versorgungsspannung des Schaltkreises IC1. D1 ist eine Gleichrichterdiode zur Blockade negativer Spannungsspitzen gegenüber der Versorgungsspannung von IC1. D2 hat die gleiche Funktion gegenüber der Versorgungsspannung von VR1. D3 ist eine Begrenzungsdiode, die bei Überschreitung eines definierten Spannungspegels leitend wird.

Der verwendete Temperatursensor VR1 erzeugt ein temperaturproportionales, tastgradmoduliertes Ausgangssignal mit einer Frequenz f von ca. 3 kHz.

Zwischen den Anschlußpunkten GND und VCC wird die notwendige Stromversorgung angelegt, die Anschlußpunkte A und B stellen das aufbereitete Meßsignal zur Weiterverarbeitung bzw. Fernübertragung zur Verfügung.

Der Temperatursensor VR1 besitzt eine in einen Chip eingebrannte Sensorstruktur, so daß ein zusätzliches Kalibrieren entfällt.

Entsprechende Temperatursensoren sind derzeit kommerziell verfügbar.

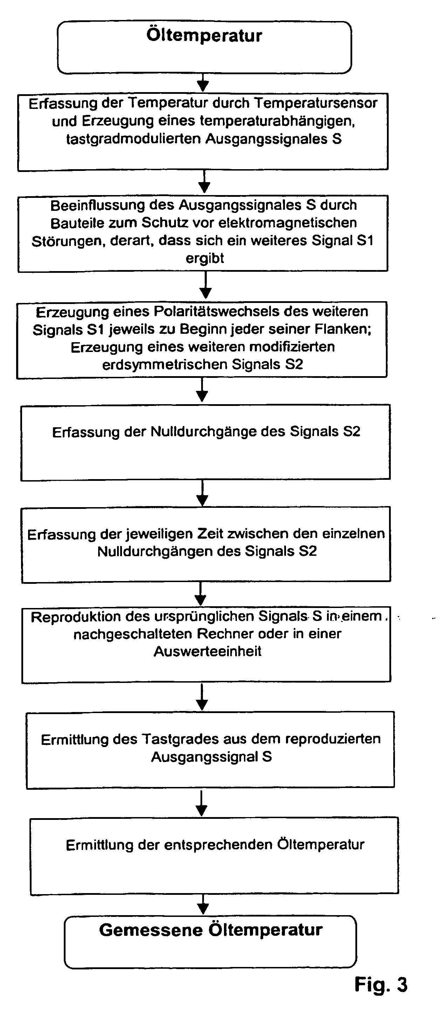

Fig. 3 zeigt in schematischer Darstellung den Ablauf des erfindungsgemäßen Verfahrens unter Verwendung des soeben beschriebenen Meßwertaufnehmers.

Zunächst wird, abhängig von der jeweils am Meßort herrschenden Öltemperatur, durch den Temperatursensor VR1 ein temperaturabhängiges, tastgradmoduliertes Ausgangssignal S erzeugt, das Impulse enthält, deren jeweiliges Tastverhältnis ein Maß für die aktuelle gemessene Temperatur ist.

Dieses Ausgangssignal S durchläuft zum Schutz vor elektromagnetischen Störungen eine aus verschiedenen Bauteilen bestehende Beschaltung; es erfolgt eine Flankenverschleifung und es ergibt sich ein weiteres Signal S1, das vom ursprünglich generierten, streng digitalen, Signal S abweicht. Die erläuterte Flankenverschleifung ist bedingt durch die Zeitkonstanten der verwendeten Bauteile.

Nachfolgend wird durch einen Interfaceschaltkreis IC1 ein Polaritätswechsel des Signals S1 zu Beginn jeder Flanke dieses Signals S1 erzeugt und weiterhin ein weiteres, erdsymmetrisches Signal S2 erzeugt, das jedoch die Form des Signals S1 behält.

Die Flankenverschleifung des erhaltenen Signals S2 kann das Pulsbreitenverhältnis und damit die Temperaturmessung nicht negativ beeinflussen, da als nachfolgender Verfahrensschritt lediglich die einzelnen Nulldurchgänge dieses erdsymmetrischen Signales S2 erfasst werden.

Nachfolgend wird die jeweilige Zeit zwischen den einzelnen Nulldurchgängen des erdsymmetrischen Signals S2 als Maß für die jeweils gemessene Temperatur T erfasst, das ursprüngliche Ausgangssignal S reproduziert und schließlich aus dem reproduzierten Ausgangssignal S der Tastgrad g(T) und aus diesem wiederum die entsprechende Temperatur T ermittelt.

In Fig. 4 sind noch einmal die beschriebenen Signale S, S1 und S2 schematisch dargestellt. Ganz oben in der Darstellung ist das streng digitale, mäanderförmige tastgradmodulierte und temperaturproportionale Signal S zu sehen.

Ebenfalls sind die Formeln für die Ermittlung des Tastgrades g sowie für den Zusammenhang zwischen der Temperatur T und dem Tastgrad aufgeführt.

In der Darstellung darunter ist das Signal S1 dargestellt, nachdem es die EMV-Beschaltung durchlaufen hat, so wie es sich nach dem Stand der Technik ergibt. Deutlich ist hier die Verschleifung der Flanken zu erkennen. Ebenfalls dargestellt ist ein weiteres Phänomen, nämlich ein auftretender Zeitfehler und damit Temperaturfehler bei der zugrundegelegten Tastgradmodulation, der ebenfalls das Ergebnis verfälschen kann. Hierbei ist zu berücksichtigen, daß infolge der Zeitkonstanten der verwendeten Bauteile für die EMV-Beschaltung sich das Tastverhältnis durch eine Veränderung des Tastgrades ebenfalls verändert. Es ergibt sich damit bei einer wirkenden zeitlichen Veränderung $\Delta t_1$, nachfolgend

$$\frac{t_d + \Delta ti}{t_p + \Delta t_1} \neq \frac{t_d}{t_p}$$

als Zeitfehler bezeichnet, folgender Zusammenhang:

Dieser Sachverhalt ist in Figur 4 dargestellt. Die gepunktete Linie zeigt die theoretischen Umschaltpunkte des Signals, die Strich-Punkt-Linie zeigt die praktischen, fehlerbehafteten Werte, die sich ergeben durch die beschriebenen Bauteile sowie die zusätzlich auftretende Schalthysterese.

In Figur 4 ist oben das Signal S dargestellt, dies ist das theoretisch auftretende Signal bei Leerlauf von VR1. In der Mitte ist das Signal S1 dargestellt, dies ist das reale Signal des belasteten Temperatursensors VR1. Wiederum darunter ist das erfindungsgemäß generierte Signal S2 dargestellt. Hier ist der Polaritätswechsel zu Beginn jeder Flanke an den beiden Ausgängen A, B deutlich zu erkennen.

Es kann nun, wie beschrieben, auf einfache Weise der jeweilige Nulldurchgang des Signales S2 ermittelt und aus den dazwischenliegenden Zeitabständen die gleiche Information gewonnen werden, die sich auch aus dem Tastgrad, d.h. dem Tastverhältnis des ursprünglichen Signals S ergibt: die jeweilige Temperatur. Mit anderen Wort: Durch geeignete Mittel, beispielsweise eine Komparatorschaltung, enthaltend einen Operationsverstärker mit geringer Hysterese, wird aus dem generierten Signal S2 wieder das ursprüngliche Signal S erzeugt. Weder Flankenverschleifungen noch zusätzliche Fehler durch auftretende Zeitkonstanten beeinflussen das Ergebnis und damit die exakt ermittelbare Temperatur.

**Patentansprüche**

1. Messwertaufnehmer zur Temperaturmessung an ölgefüllten Betriebsmitteln, insbesondere an Transformatoren oder Stufenschaltern, mit

   - einem Temperatursensor (VR1), der ein tastgradmoduliertes Ausgangssignal (S) erzeugt, indem er Impulse generiert, deren jeweiliges Tastverhältnis ein Maß für die aktuell gemessene Temperatur ist,
   - Bauteilen (D1, D2, D3, C1, C2), die zum Temperatursensor (VR1) geschaltet sind und dem Schutz vor elektromagnetischen Störungen dienen, wobei sich unter dem Einfluss dieser Bauteile aus dem genannten Ausgangssignal (S) ein weiteres Signal (S1) ergibt,
   - einem Interfaceschaltkreis (IC1), der einen Polaritätswechsel des genannten Signals (S1) zu Beginn jeder Flanke des Signals (S1) ausführt und ein weiteres, erdsymmetrisches Signal (S2) an eine Auswerteeinheit abgibt, das die Form des vom Temperatursensor (VR1) übermittelten und durch die genannten Bauteile (D1, D2, D3, C1, C2) beeinflussten Signals (S1) behält, und
   - einem Gehäuse eines Widerstandsthermometers, in dem der Temperatursensor (VR1), der Interfaceschaltkreis (IC1) und die genannten Bauteile (D1, D2, D3, C1, C2) angeordnet sind.

2. Verfahren zur Temperaturmessung an ölgefüllten Betriebsmitteln, insbesondere an Transformatoren oder Stufenschaltern, wobei

   - ein temperaturabhängiges, tastgradmoduliertes Ausgangssignal (S) erzeugt wird, das Impulse enthält, deren jeweiliges Tastverhältnis ein Maß für die aktuell gemessene Temperatur ist,

   - das erzeugte Ausgangssignal (S) durch zum Schutz vor elektromagnetischen Störungen dienenden Bauteile beeinflusst wird, so dass sich ein weiteres Signal (S1) ergibt,
   - ein Polaritätswechsel des genannten Signals (S1) zu Beginn jeder Flanke dieses Signals (S1) erzeugt wird und ein weiteres, erdsymmetrisches Signal erzeugt wird, das die Form des genannten Signals (S1) behält,
   - die einzelnen Nulldurchgänge des erdsymmetrischen Signals (S2) erfasst werden,
   - die jeweilige Zeit zwischen den einzelnen Nulldurchgängen des erdsymmetrischen Signals (S2) als Maß für die jeweils gemessene Temperatur (T) erfasst wird,
   - anschließend das ursprüngliche Ausgangssignal (S) reproduziert wird, und
   - aus dem reproduzierten Ausgangssignal (S) der Tastgrad (g(T)) und aus diesem wiederum die entsprechende Temperatur (T) ermittelt wird.

**Claims**

1. Measurement value pick-up for temperature measurement at oil-filled operating means, particularly at transformers or tap changers, comprising

   - a temperature sensor (VR1), which produces an output signal (S), which is modulated in duty factor, in that it generates pulses, the respective pulse-duty factor of which is a measure for the actually measured temperature,
   - components (D1, D2, D3, C1, C2), which are connected with the temperature sensor (VR1) and which serve for protection against electromagnetic disturbances, wherein a further signal (S1) results from the said output signal (S) under the influence of these components,
   - an interface circuit (IC1), which carries out a polarity change of the said signal (S1) at the beginning of each flank of the signal (S1) and delivers a further, balanced signal (S2) to an evaluating unit which contains the form of the signal transmitted by the temperature sensor (VR1) and influenced by the said components (D1, D2, D3, C1, C2), and
   - a housing of a resistance thermometer, in which the temperature sensor (VR1), the interface circuit (IC1) and the said components (D1, D2, D3, C1, C2) are arranged.

2. Method of temperature measurement at oil-filled operating means, particularly at transformers or tap changers, wherein

- a temperature-dependent output signal (S) is produced, which is modulated in duty factor and which contains pulses, the respective pulse-duty factor of which is a measure for the actually measured temperature,
- the output signal (S) produced is influenced by components, which serve for protection against electromagnetic disturbances, so that a further signal (S1) results,
- a polarity change of the said signal (S1) is produced at the beginning of each flank of this signal (S1) and a further, balanced signal is produced which contains the form of the said signal (S1),
- the individual zero transitions of the balanced signal (S2) are detected,
- the respective time between the individual zero transitions of the balanced signal (S2) is detected as a measure for the respectively measured temperature (T),
- subsequently the original output signal (S) is reproduced and
- the duty factor (g(T)) is ascertained from the reproduced output signal (S) and from this factor in turn the corresponding temperature (T) is ascertained.

**Revendications**

1. Transducteur pour mesurer la température dans des installations remplies d'huile, en particulier des transformateurs ou des combinateurs, comprenant :

   - un capteur de température (VR1) qui génère un signal de sortie (S) modulé en durée d'impulsion en générant des impulsions dont le facteur d'utilisation respectif est une valeur pour la température actuellement mesurée,
   - les composants (D1, D2, D3, C1, C2) qui sont reliés au capteur de température (VR1) et servent à la protection contre des perturbations électromagnétiques, un autre signal (S1) étant obtenu à partir du signal de sortie (S) sous l'influence de ces composants,
   - un circuit interface (ICI) exécute un changement de polarité du signal cité (S1) au début de chaque flanc du signal (S1) et délivre un autre signal (S2) équilibré à une unité d'exploitation, qui conserve la forme du signal (S1) transmis par le capteur de température (VR1) et influencé par les composants (D1, D2, D3, C1, C2) cités, et
   - un boîtier d'un thermomètre à résistance dans lequel sont disposés le capteur de température (VR1), le circuit interface (ICI) et les composants (D1, D2, D3, C1, C2).

2. Procédé de mesure de température dans des installations remplies d'huile, en particulier des transformateurs ou des combinateurs, dans lequel

   - un signal de sortie (S) dépendant de la température modulé en durée d'impulsion est généré, il contient des impulsions dont le facteur d'utilisation respectif est une valeur pour la température actuellement mesurée.
   - le signal de sortie (S) généré est influencé par des composants servant à la protection contre des perturbations électromagnétiques, pour ainsi obtenir un autre signal (S1),
   - un changement de polarité du signal (S1) est généré au début de chaque flanc de ce signal (S1), et un autre signal équilibré qui conserve la forme du signal (S1) est généré,
   - les différents passages par zéro du signal équilibré (S2) sont détectés,
   - le temps respectif entre les différents passages par zéro du signal équilibré (S2) est détecté comme valeur pour la température (T) respectivement mesurée,
   - ensuite le signal de sortie (S) initial est reproduit, et
   - à partir du signal de sortie (S) reproduit, la durée d'impulsion (g(T)) est déterminée et à partir de celle-ci la température (T) correspondante.

Fig. 1

Fig.2

Öltemperatur

Erfassung der Temperatur durch Temperatursensor und Erzeugung eines temperaturabhängigen, tastgradmodulierten Ausgangssignales S

Beeinflussung des Ausgangssignales S durch Bauteile zum Schutz vor elektromagnetischen Störungen, derart, dass sich ein weiteres Signal S1 ergibt

Erzeugung eines Polaritätswechsels des weiteren Signals S1 jeweils zu Beginn jeder seiner Flanken; Erzeugung eines weiteren modifizierten erdsymmetrischen Signals S2

Erfassung der Nulldurchgänge des Signals S2

Erfassung der jeweiligen Zeit zwischen den einzelnen Nulldurchgängen des Signals S2

Reproduktion des ursprünglichen Signals S in einem nachgeschalteten Rechner oder in einer Auswerteeinheit

Ermittlung des Tastgrades aus dem reproduzierten Ausgangssignal S

Ermittlung der entsprechenden Öltemperatur

Gemessene Öltemperatur

**Fig. 3**

S

Umschaltpegel   Low-High

Umschaltpegel   High-Low

t

$t_d$

$t_p$

Tastgrad $g(T) = t_d / t_p$

Temperatur $T = 212{,}766 * (t_d / t_p - 0{,}32)$ in °C

**Ursprungssignal am Sensorausgang**

S1

Umschaltpegel   Low-High

Umschaltpegel   High-Low

t

ist   Zeitfehler = Temperaturfehler durch Verfälschung

soll   des Tastverhältnisses

Ein        Aus

**A) Unsymetrische Einfachstrom-Schnittstelle**

S2

Ausgang A

Umschaltpegel  Low-High

t

Umschaltpegel  High-Low

Ausgang B

Ein        Aus

**B) Erdsymetrische Doppelstrom-Schnittstelle**

**Fig. 4**